(19) Europäisches Patentamt
European Patent Office
Office européen des brevets

(11) Veröffentlichungsnummer: **0 071 816**
**A1**

(12) # EUROPÄISCHE PATENTANMELDUNG

(21) Anmeldenummer: **82106504.2**

(22) Anmeldetag: **19.07.82**

(51) Int. Cl.³: **G 01 R 31/36**

(30) Priorität: **03.08.81 DE 3130669**

(43) Veröffentlichungstag der Anmeldung: **16.02.83**
**Patentblatt 83/7**

(84) Benannte Vertragsstaaten: **AT DE FR GB IT SE**

(71) Anmelder: **Möhrstedt, Udo, Angerstrasse 50,**
**D-8623 Staffelstein (DE)**

(72) Erfinder: **Möhrstedt, Udo, Dipl.-Phys., Angerstrasse 50,**
**D-8623 Staffelstein (DE)**
Erfinder: **Becher, Mark, Dr. Dipl.-Phys., Jahnstrasse 35,**
**D-8501 Feucht (DE)**
Erfinder: **Lengenfelder, Walter, Ing. (grad),**
**Wiesentalstrasse 10, D-8501 Schwaig/Nbg. (DE)**

(74) Vertreter: **Haft, Uwe Michael, Dipl.-Phys. et al,**
**Patentanwälte Haft, Berngruber, Czybulka**
**Hans-Sachs-Strasse 5, D-8000 München 5 (DE)**

(54) **Verfahren und Vorrichtung zur Messung des Ladezustandes einer Batterie.**

(57) Das erfindungsgemäße Verfahren und seine Vorrichtung bestehen darin, daß ein Impulsgenerator (I) einen Impuls erzeugt, dessen Länge eine Funktion der Batterie-Klemmenspannung während der ersten Startzeit ist, daß dieser Impuls einem auftastbaren Stromstabilisator zugeführt wird, dessen Ladungsmenge in ein Speicherbauelement (Mem) eingegeben wird. Ein Shunt-Widerstand (R1) mißt die während der Belastung der Batterie auftretenden Lade- bzw. Entladeströme, die einem Gleichstromverstärker (III) zugeführt werden, dessen Ausgangsströme vorzeichenrichtig dem Speicherbauelement zugeführt werden. Der addierte Strom im Speicherbauelement erzeugt ein Steuersignal, das nach Unterschreiten eines bestimmten Grenzwertes ein Schaltelement für die Start- und Stop-Automatik des Fahrzeuges und/oder eine optische Anzeigevorrichtung (LED) für den Benutzer betätigt, um ihn so über den Ladezustand seiner Batterie zu informieren.

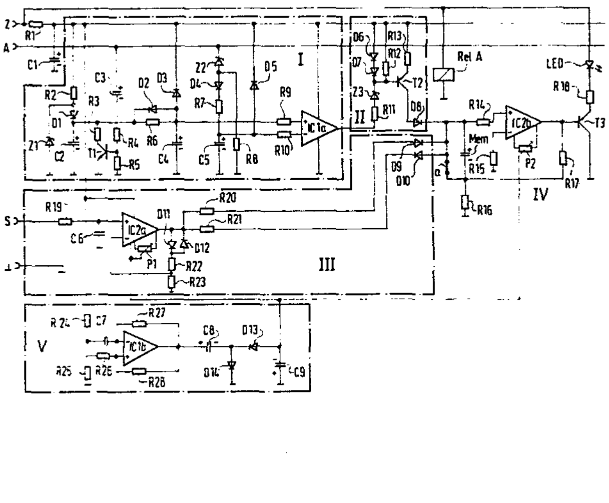


EP 0 071 816 A1

Udo Möhrstedt, Angerstr. 50, 8623 Staffelstein

Verfahren und Vorrichtung zur Messung des Ladezustandes einer Batterie

Die vorliegende Erfindung betrifft ein Verfahren zur Messung des Ladezustandes einer Batterie, insbesondere einer Starterbatterie für Fahrzeuge, sowie eine geeignete Vorrichtung dafür.

Die Entwicklungsrichtung im modernen Kraftfahrzeugbau geht dahin, aus Ersparnisgründen möglichst häufig im innerstädtischen Verkehr bei kurzen Standzeiten , z.B. an Ampeln, den Motor abzuschalten, sofern das Kraftfahrzeug angehalten werden muß. Springt nun die Ampel auf grün, so muß der Motor wieder gestartet werden. Dieser Einsatz (Start und Stop) kann sowohl automatisch als auch manuell erfolgen. Er ist jedoch nur dann möglich, wenn dem Fahrzeughalter ab eines bestimmten Ladezustandes signalisiert wird, daß aufgrund auch beim Motorstillstand eingeschalteten elektrischer Verbraucher, wie z.B. Lampen, Gebläse, Heckscheibenheizung, Radio usw., der Ladezustand der Batterie einem kritischen Grenzwert zustrebt, bei dem nicht mehr sichergestellt ist, daß das Fahrzeug gestartet werden kann.

Der Ladezustand einer Batterie läßt sich der Säuredichte zuordnen und diese wiederum einer Ruhespannung $U_0$. Dies ist die Klemmenspannung, die sich einstellt, wenn die Batterie eine bestimmte Zeit lang nicht belastet worden ist. Die Ruhespannung ist wiederum von der Temperatur in erster Näherung als unabhängig anzusehen.

Batterien altern im wesentlichen durch zwei Prozesse, nämlich das Abschlammen der positiven Massen und die Korrosion des positiven Gitters. Daneben findet man auch Batterien, bei denen die negativen Massen sulfatiert sind und ihre hohe Porosität

infolge von Sulfatierung verloren haben. Die Alterungsmechanismen bewirken, daß beim Entladen mit verschiedenen Strömen die Klemmenspannung $U_B$ kleiner ist als bei einer neuen Batterie.

In der Praxis hält eine Batterie so lange, bis beim Anlassen des Fahrzeuges ein Grenzwert der Klemmenspannung erreicht ist, der im allgemeinen 6,5 Volt bis 7 Volt beträgt. Unterhalb dieser Grenze starten Fahrzeuge im allgemeinen nicht mehr. Es ist dabei für die Praxis unwichtig, ob die Klemmenspannung wegen Kälte oder in der Wärme wegen verbrauchter oder entladener Batterie auf diesen Grenzwert absinkt.

Es wurden bereits mehrere Ladezustands-Anzeigegeräte entwickelt, die aber entweder einen sehr hohen Preis bedingen oder unzuverlässige Werte anzeigten oder sehr kompliziert im Aufbau waren. Eine Möglichkeit besteht darin, vor Startbeginn die Ruhespannung $U_0$ zu messen, mit der allerdings nur ein grober Zustand für den Ladezustand einer Batterie angebbar ist. Durch die daraus ermittelte Säuredichte kann durch Anwendung einer geeigneten Formel ein ungefährer Ladezustand von 100%, 50 % oder etwa 10 % angegeben werden.

Die Messung des Ladezustandes rein über die Ruhespannung hat den Nachteil, daß sie weder die Abhängigkeit der Klemmenspannung beim Starten vom Alter der Batterie noch von der Temperatur berücksichtigt. Sie kann dem Fahrer nur signalisieren, ob die Batterie sich in einem tiefen, mittleren oder guten Ladezustand befindet. Ferner muß als Voraussetzung für eine richtige Messung der Ruhezustand gewährleistet sein, daß die Batterie mindestens eine Stunde lang nicht belastet worden ist.

Der vorliegenden Erfindung liegt die Aufgabe zugrunde, ein besonders einfaches und wirtschaftliches Verfahren sowie eine Vorrichtung zur Messung des Ladezustandes einer Batterie zu schaffen, insbesondere der Starterbatterie eines Fahrzeugs, mit denen der Benutzer zuverlässig über den Zustand der Batterie

informiert wird, so daß der angestrebte Start- und Stop-Betrieb im innerstädtischen Verkehr problemlos ermöglicht wird.

Die Lösung der Aufgabe ein derartiges Verfahren anzugeben, ist durch die im kennzeichnenden Teil des Anspruches 1 angegebenen Merkmale gelöst. Die Aufgabe eine derartige Vorrichtung anzugeben, ist durch die im kennzeichnenden Teil des Anspruchs 7 angegebenen Merkmale gelöst. Vorteilhafte Weiterbildungen der Erfindung sind in den Unteransprüchen beschrieben.

Mit der vorliegenden Erfindung wird also der Vorteil erzielt, ein einfaches, billiges, wirkungsvolles Verfahren bzw. Vorrichtung zu schaffen, die dem Benutzer zuverlässig den Ladezustand seiner Batterie anzeigt, und zwar durch Messung der Klemmenspannung beim Start und durch Messung der Lade- bzw. Entladeströme der Batterie während ihrer Belastung, wodurch die Entwicklung der Batteriespannung für einen folgenden Startvorgang ermittelt wird, so daß bei Annäherung der Batteriespannung an einen vorgegebenen Grenzwert dem Benutzer ein optisches Signal gegeben wird und/oder der Start- und Stop-Einrichtung ein Steuersignal zugeführt wird. Damit ist gewährleistet, daß bei schlechtem Zustand der Batterie das Fahrzeug bei kurzen Standzeiten im innerstädtischen Verkehr nicht mehr angehalten wird und so auch keine Gefahr mehr besteht, daß der Motor beim nächsten Startvorgang nicht mehr anspringt.

Im folgenden wird die Erfindung anhand der Zeichnung näher erläutert, in der zwei bevorzugte Ausführungsbeispiele dargestellt sind. Es zeigen:

Figur 1 ein Schaltbild einer erfindungsgemäßen Vorrichtung zur Durchführung des Verfahrens und

Figur 2 ein Anschlußbild für die in Figur 1 gezeigte Schaltung in einem Fahrzeug.

Gemäß dem erfindungsgemäßen Verfahren wird während der Erstbelastung der Batterie, d.h. während des Startens während der ersten Sekunden (ca. 10 Sekunden) die Klemmenspannung an den Endpolen der Batterie gemessen und einem Impulsgenerator zugeführt, der einen Impuls erzeugt, dessen Länge von der Höhe der Klemmenspannung während des Startvorgangs abhängt. Da nur während einiger Sekunden, z.B. 10 Sekunden, die Klemmenspannung gemessen wird, ist die Impulsdauer insgesamt unabhängig von der Länge des Startvorganges. Eine geeignete Impulslänge bei einer Klemmenspannung während des Startvorgangs von 11 Volt beträgt ca. 5 Sekunden, während die Impulsdauer bei einer Klemmenspannung während des Startvorgangs von 7,5 Volt 0 Sekunden beträgt.

Der vom Impulsgenerator während der Erstbelastung der Batterie erzeugte Impuls tastet nun einen Stromstabilisator auf, der entsprechend der Impulslänge eine bestimmte Ladungsmenge einem Speicherbauelement zuführt. Das Speicherbauelement ist insbesondere eine Memoriode, die diesen Wert speichert.

Der während der Erstbelastung der Batterie erzeugte Impuls besitzt allerdings nur einen vernünftigen Aussagewert im stationären Zustand, d.h. wenn das damit versehene Fahrzeug bereits einige Zeit gefahren ist und der Motor eine bestimmte Betriebswärme angenommen hat. Beim morgentlichen Start, z.B. nach einer kalten Winternacht, ist der Startstrom nämlich bedeutend höher und damit die Klemmenspannung sehr viel niedriger. Dies kann dazu führen, daß aufgrund des morgentlichen Starts die Startgrenzspannung erreicht oder fast erreicht ist.

Beim weiteren Fahren , d.h. durch die Erwärmung des Motors , geht automatisch der Startstrom beim nächsten Start zurück.

Der während der weiteren Belastung der Batterie nun auftretende Lade- oder Entladestrom wird fernerhin gemessen, und eventuell nach Verstärkung vor Zeichenrichtung der im Speicherbauelement

gespeicherten Ladungsmenge addiert. Das Speicherbauelement gibt nun ein diesen addierten Werten entsprechendes Steuersignal ab,welches ein Maß für den Ladezustand der Batterie ist und das zur Steuerung einer optischen Anzeige und/oder einer Start- und Stop-Automatik des Fahrzeugs verwendet werden kann.

Während der Fahrt oder während der Motor läuft, wird üblicherweise die Batterie je nach Drehzahl des Motors und je nach Zahl der eingeschalteten Verbraucher, entweder geladen oder entladen. Steht das Fahrzeug wird in jedem Fall die Batterie aufgrund der eingeschalteten Verbraucher nur entladen. So lange die Klemmenspannung aufgrund des Ladestroms gegenüber dem vorangegangenen Start steigt, besteht für den Fahrzeughalter keine Gefahr. Diese würde erst dann eintreten, wenn die Klemmenspannung einen Grenzwert erreicht, der üblicherweise zwischen 6,5 und 7 Volt liegt. In diesem Fall ist nicht mehr gewährleistet, daß das Fahrzeug nach dem nächsten Stillstand wieder anspringt.

Das vom Speicherbauelement abgegebene Signal ist eine dem addierten Strom im Speicherbauelement entsprechende Spannung, wobei vorteilhafterweise das Speicherbauelement mit einem Regler versehen ist, so daß die dem addierten Strom im Speicherbauelement entsprechende Spannung nur beim Unterschreiten eines bestimmten einstellbaren Grenzwertes abgegeben wird. Wird dieser Grenzwert unterschritten, so steuert die vom Speicherbauelement abgegebene Spannung ein Anzeige- und/oder Schaltelement,mit dem z.B. dem Fahrer eine optische Anzeige über den schlechten Ladezustand der Batterie und/oder der Start- und Stop-Automatik ein Signal zugeführt wird, demzufolge der Motor nicht abzuschalten ist, da der nächste Startvorgang nicht mehr gewährleistet ist.

Vorteilhafterweise wird das Speicherbauelement bei abgeschalteter Zündung über eine Relais-Kontakt entladen um für einen erneuten Startvorgang einen definierten Ausgangspunkt zu haben.

Figur 1 zeigt ein Schaltbild einer erfindungsgemäßen Vorrichtung zur Durchführung des Verfahrens und Figur 2 ein Anschlußbild für den Einbau in die elektrische Anlage eines Fahrzeugs. In Figur 2 ist mit 1 die Batterie bezeichnet, mit 2 das Zündschloß des Fahrzeuges, mit 3 die Leitung für das Anlaß-Relais und mit 4 die Leitung für die Zündung. Mit 5 ist ein Shunt-Widerstand von z.B. 1 $\Omega$ bezeichnet zur Messung der Lade- bzw. Entladeströme während des Betriebs und mit 6 die in Figur 1 näher dargestellte Schaltung.

Mit Z ist dabei der Anschluß für das Zündkabel, mit A der Anschluß für das Anlaß-Relais, mit S der Anschluß für den Shunt-Widerstand und mit $\perp$ der Anschluß für die Masse bezeichnet. I in Figur 1 bezeichnet einen Impulsgenerator, der während der Erstbelastung der Batterie, d.h. während des Startvorgangs einen Impuls erzeugt, dessen Länge von der Höhe der Klemmenspannung während des Startvorgangs bestimmt wird und zwar während der ersten Sekunden. Eine geeignete Impulslänge beträgt z.B. 5 Sekunden bei einer Klemmenspannung von 11 Volt und 0 Sekunden bei einer Klemmenspannung von 7,5 Volt während der ersten Sekunden des Startvorgangs. Die gesamte Länge des Startvorgangs ist dabei ohne Bedeutung.

Der vom Impulsgenerator I erzeugte Impuls wird nun einem Stromstabilisator II zugeführt und tastet diesen auf. Der Stromstabilisator II gibt nun über die Diode D8 eine Ladungsmenge in das Speicherbauelement Mem. ab, das z.B. eine Memoriode ist. Der Wert der Ladungsmenge ist nunmehr ein Maß für die Höhe der Klemmenspannung während des Startvorgangs (I = konstant, t = variabel).

Der nun während des Betriebs des Fahrzeugs auftretende Batterie-Lade- bzw. Entladestrom wird über den in Figur 2 dargestellten Shunt-Widerstand von z.B. 1 $\Omega$ gemessen (Spannungsabfall z.B. 1 mV/A) und einen Gleichstromverstärker III zugeführt, in dem er verstärkt wird. Der Ausgangsstrom des Gleichstromverstärkers

III wird entweder über den Widerstand R20 und die Diode D9 oder über den Widerstand R21 und die Diode D10 je nach seinem Vorzeichen dem Speicherbauelement , d.h. der Memoriode vorzeichenrichtig zugeführt und zu der beim Startvorgang eingebrachten Ladung addiert. Die Memoriode Mem. erzeugt nun ein von der Größe der addierten Ströme abhängiges Signal , wobei dieses Signal eine Spannung ist, die mit dem Regler P2 einstellbar ist. Unterschreitet nun die von der Memoriode abgegebene Spannung einen bestimmten Wert, so wird der Schaltverstärker IV angesteuert, der z.B. über eine Treibertransistor T3 ein Schaltelement und/oder ein mit LED bezeichnetes optisches Anzeigegerät ansteuert. Durch das Schaltelement wird der Start- und Stop-Automatik der Befehl erteilt, den Motor nicht abzuschalten, da nunmehr der Ladezustand der Batterie zu gering ist, so daß die Möglichkeit besteht, daß das Fahrzeug nicht mehr startet. Zur gleichen Zeit kann durch die LED-Anzeige dem Fahrer optisch angezeigt werden, in welchem Ladezustand sich seine Batterie befindet.

Um im Schaltpunkt selbst ein bestimmtes "Flattern" zu vermeiden, ist der Schaltverstärker IV mit einer Hysterese-Einrichtung versehen.

Mit V ist fernerhin eine Schaltung zur Erzeugung einer negativen Betriebsspannung bezeichnet. A wiederum bezeichnet einen Relais-Kontakt , über den die Memoriode bei abgeschalteter Zündung entladen wird um für einen neuen Startvorgang einen definierten Ausgangspunkt zu erhalten.

Ein Problem bei der Berechnung der korrigierten auf den augenblicklichen Zustand bezogenen Klemmenspannung besteht noch darin, daß die Klemmenspannung nicht nur vom Ladezustand der Batterie, sondern auch von deren Temperatur abhängt. Dabei besteht ein geringfügiger Unterschied darin, ob ausgehend von einem Ladezustand von 30 % die Batterie auf einen Ladezustand von 50 % gebracht wird oder ob die Batterie ausgehend von einem Ladezustand von 50 % auf einen Ladezustand von 70 % gebracht wird.

Die aufgenommene Strommenge ist zwar in jedem Falle die gleiche, jedoch ergibt sich aufgrund der Batterie-Kennlinie im zweiten Fall ein geringfügig kleinerer Anstieg der Klemmenspannung als im ersten Fall. Fernerhin ändert sich die Klemmenspannung auch mit der Temperatur, wobei dafür die folgende Abhängigkeit gilt:

$$\frac{\Delta U}{\Delta T} : \quad \frac{7\ mV/C°}{40\ °C} \quad \frac{40\ mV/C°}{0°C} \quad \frac{66\ mC/C°}{-20°C}$$

wobei mit den unteren Werten die Bezugstemperatur bezeichnet ist. Eine weitere Korrekturmöglichkeit besteht nun darin, durch einen geeigneten Temperaturfühler, z.B. ein Thermoelement, das in der Batterie, d.h. im Elektrolyt oder im Batteriepol angeordnet ist, und das mit einem geeigneten Schaltkreis verbunden ist, ein Korrektursignal zu erzeugen, das direkt oder indirekt, d.h. nach geeigneter Umformung , dem Speicherbauelement zugeführt wird, um das abgegebene Spannungssignal der Memoriode noch hinsichtlich der Temperatur zu korrigieren.

Die vorliegende Erfindung ermöglicht also auf besonders einfache , wirkungsvolle und billige Weise, eine ständige Anzeige des Ladezustandes der Batterie während des Betriebes und eine Steuerung der Start- und Stop-Automatik von Fahrzeugen zu gewährleisten.

0071816

**Uwe M. Haft**

**Patentanwalt**
European Patent Attorney

Hans-Sachs-Str. 5
D-8000 München 5
Tel.: (089) 2607671
Telex: 523514

Unser Zeichen/Our ref.: 1658

Datum/date:



Udo Möhrstedt, Angerstr. 50, 8623 Staffelstein

P a t e n t a n s p r ü c h e

1. Verfahren zur Messung des Ladezustands einer Batterie, insbesondere einer Starterbatterie für Fahrzeuge, dadurch g e k e n n z e i c h n e t , daß: während der Erstbelastung der Batterie ein Impuls erzeugt wird, dessen Länge von der Größe der bei der Belastung herrschenden Batterie-Klemmenspannung abhängt, daß dieser Impuls eine von seiner Dauer bestimmte Ladungsmenge erzeugt, daß diese Ladungsmenge einem Speicherbauelement zugeführt wird, daß der bei weiterer Belastung der Batterie auftretende Lade- oder Entladestrom gemessen wird und (eventuell nach Verstärkung) vorzeichenrichtig der im Speicherbauelement der gespeicherten, eine Funktion der Batteriespannung bei Erstbelastung darstellenden Ladungsmenge addiert wird, und daß das Speicherbauelement ein Signal als Funktion des addierten Stroms abgibt, das zur Steuerung einer optischen Anzeige und/oder einer Start- und Stop-Automatik des Fahrzeugs verwendet wird.

2. Verfahren nach Anspruch 1, dadurch gekennzeichnet, daß das vom Speicherbauelement abgegebene Signal eine dem addierten Strom im Speicherbauelement entsprechende Spannung ist , und daß das Speicherbauelement mit einem Regler versehen ist, so daß die dem addierten Strom im Speicherbauelement entsprechende Spannung nur bei Überschreiten eines bestimmten einstellbaren Grenzwertes abgegeben wird.

3. Verfahren nach Ansprüchen 1 und 2, dadurch gekennzeichnet, daß als Erstbelastung der Batterie der Startvorgang verwendet wird, daß der Impuls während einer Startdauer von einigen Sekunden, aber unabhängig von der gesamten Startdauer, erzeugt wird, daß dieser Impuls , dessen Länge eine Funktion der Größe der Start-Klemmenspannung ist, einem Stromstabilisator zugeführt wird und diesen auftastet, daß dem Stromstabilisator eine von der Impulslänge bestimmte Ladungsmenge dem Speicherbauelement über eine Diode zugeführt wird, daß der bei Betrieb der Batterie auftretende Batterie-Lade- bzw. Entladestrom über einen Shunt-Widerstand gemessen und dieser Meßstrom einem Gleichstromverstärker zugeführt wird, dessen verstärkter Ausgangsstrom, dessen Vorzeichen dem Lade- bzw. Entladestrom entspricht, dem Speicherbauelement vorzeichenrichtig zugeführt wird und der durch den Startvorgang erzeugten und gespeicherten Ladungsmenge addiert wird,und daß eine dem augenblicklichen addierten Strom entsprechende Steuerspannung vom Speicherbauelement bei Unterschreiten eines einstellbaren Grenzwertes einem Schaltverstärker zugeführt wird, der über einen Treibertransistor eine optische Anzeige und/oder ein Schaltelement ansteuert, welches verhindert, daß die Start- und Stop-Automatik des Fahrzeugs den Motor abstellt sowie eine optische Anzeige betätigt.

4. Verfahren nach einem der vorhergehenden Ansprüche, dadurch gekennzeichnet, daß bei Nichtbelastung der Batterie durch

Abschalten der Zündung des Fahrzeugs das Speicherbauelement über ein Relais-Kontakt entladen wird.

5. Verfahren nach einem der vorhergehenden Ansprüche, dadurch gekennzeichnet, daß die Temperatur der Batterie gemessen wird und ein der Temperatur entsprechendes Korrektursignal erzeugt wird, das ebenfalls dem Speicherbauelement zugeführt wird.

6. Schaltung zur Durchführung des Verfahrens nach den Ansprüchen 1 bis 5, gekennzeichnet durch:
einen Impulsgenerator zur Erzeugung eines Impulses, dessen Länge eine Funktion der Batterie-Startspannung ist,
einen von diesem Impuls auftastbaren Stromstabilisator,
ein Speicherbauelement, dem die von der Impulslänge abhängende Ladungsmenge über eine Diode zuführbar ist,
einen Shunt-Widerstand zur Messung der während der fortdauernden Belastung der Batterie auftretenden Lade- bzw. Entladeströme,
einen Gleichstromverstärker zum Verstärken dieser Ströme, dessen Ausgänge mit dem Speicherbauelement über zwei Widerstände und zwei entgegengerichtete Dioden verbunden sind, so daß die Ausgangsströme des Gleichstromverstärkers dem Speicherbauelement vorzeichenrichtig zuführbar sind,
einen Schaltverstärker mit einem Schaltelement und/oder einer optischen Anzeige, die mit dem Ausgängen des Speicherbauelementes verbunden sind,
einen Schaltkreis zur Erzeugung einer negativen Betriebsspannung und
ein mit dem Speicherelement verbundenes Relais.

7. Schaltung nach Anspruch 6, dadurch gekennzeichnet, daß der Schaltverstärker mit dem Schaltelement und/oder der optischen Anzeige über einen Treiber-Transistor verbunden ist.

0071816



8. Schaltung nach Ansprüchen 6 und 7, dadurch gekennzeichnet, daß der Schaltverstärker mit einer Hysterese versehen ist.

9. Schaltung nach Ansprüchen 6 bis 8, dadurch gekennzeichnet, daß ein Temperaturfühler in der Batterie vorgesehen ist, der mit einem Schaltkreis verbunden ist, zur Erzeugung eines temperaturabhängigen Signals und dessen Ausgang direkt oder indirekt mit dem Speicherbauelement verbunden ist.

0071816



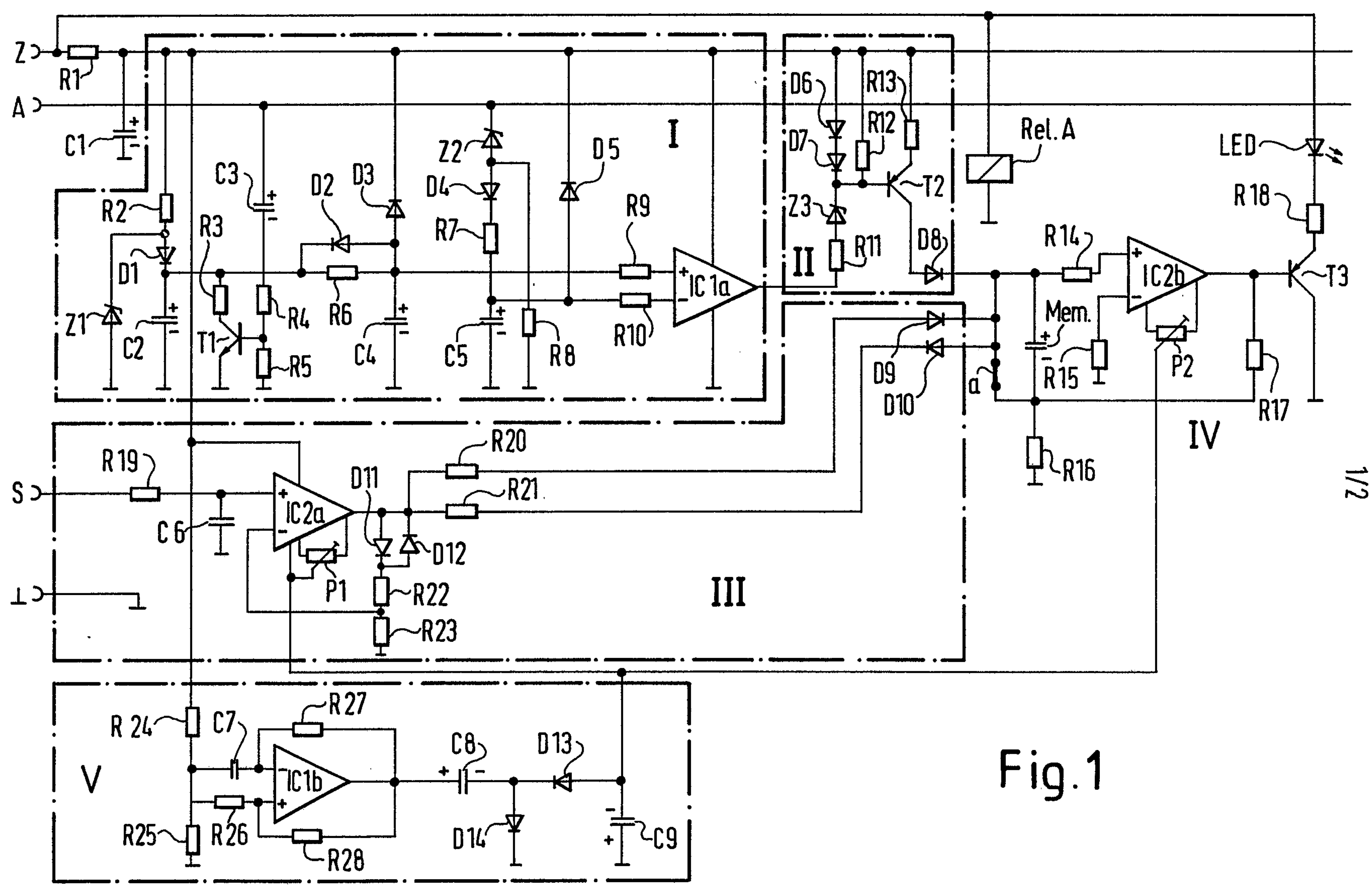


Fig.1

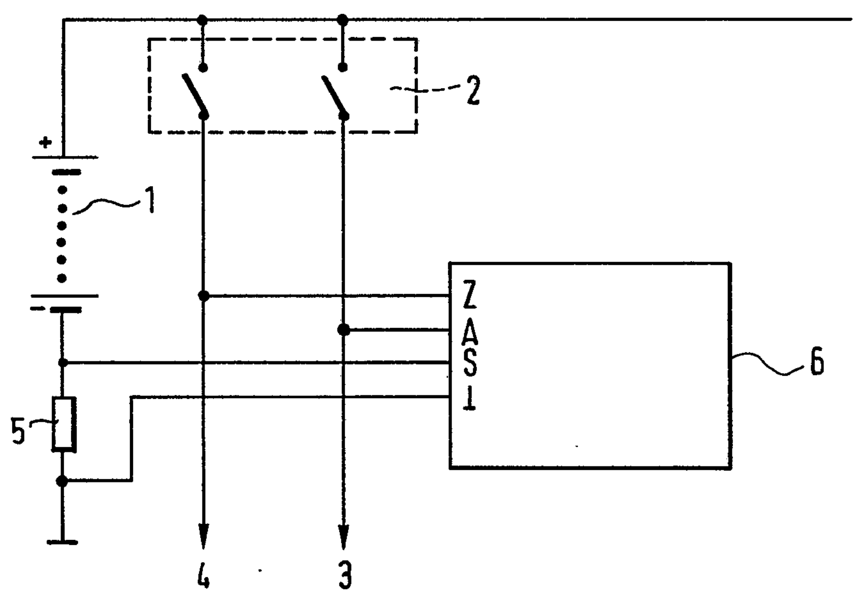


Fig. 2

0071816

Europäisches Patentamt

# EUROPÄISCHER RECHERCHENBERICHT

Nummer der Anmeldung

EP 82 10 6504.2

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| Y | DE - A1 - 2 913 900 (NIPPONDENSO CO. LTD.)<br>* Anspruch 1 ; Fig. 1 *<br>-- | 1,3,5, 9 | G 01 R 31/36 |
| Y | DE - B1 - 2 842 817 (SIEMENS AG)<br>* Anspruch 1 ; Spalte 2, Zeile 59 bis Spalte 4, Zeile 53 ; Fig. 1 *<br>-- | 1,5,9 | |
| Y | DE - B1 - 2 610 536 (SIEMENS AG)<br>* Spalte 1, Zeile 56 bis Spalte 2, Zeile 57; Spalte 4, Zeile 10 bis Spalte 5, Zeile 5 ; Fig. 3 *<br>---- | 1,3 | |

RECHERCHIERTE SACHGEBIETE (Int. Cl.³)

G 01 R 31/36

KATEGORIE DER GENANNTEN DOKUMENTE

- X: von besonderer Bedeutung allein betrachtet
- Y: von besonderer Bedeutung in Verbindung mit einer anderen Veröffentlichung derselben Kategorie
- A: technologischer Hintergrund
- O: nichtschriftliche Offenbarung
- P: Zwischenliteratur
- T: der Erfindung zugrunde liegende Theorien oder Grundsätze
- E: älteres Patentdokument, das jedoch erst am oder nach dem Anmeldedatum veröffentlicht worden ist
- D: in der Anmeldung angeführtes Dokument
- L: aus andern Gründen angeführtes Dokument
- &: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 28-10-1982 | LEMMERICH |